# EUROPÄISCHE PATENTSCHRIFT

(11) **EP 1 693 678 B1**
(45) Veröffentlichungstag und Bekanntmachung des Hinweises auf die Patenterteilung: **11.06.2008**
(21) Anmeldenummer: 06110125.9
(22) Anmeldetag: 17.02.2006
(51) Int. Cl.: G01R 15/20, G01R 19/165

(54) **Verfahren zur Messung eines Fehlerstroms und zugehörige stromsensitive Fehlerstrom-Messeinrichtung**
Method for measuring a residual current and corresponding current sensitive residual current measuring device
Procédé destiné à la mesure d'un courant différentiel résiduel et dispositif associé pour la mesure de courants différentiels sensible aux courants

(30) Priorität: 18.02.2005 DE 102005007573
(43) Veröffentlichungstag der Anmeldung: 23.08.2006
(73) Patentinhaber: SIEMENS AKTIENGESELLSCHAFT, 80333 München (DE)
(72) Erfinder: Griepentrog, Gerd, 91468, Gutenstetten (DE); Reinhard, Maier, 91074, Herzogenaurach (DE)

(56) Entgegenhaltungen:
- EP-A- 0 157 054
- PATENT ABSTRACTS OF JAPAN Bd. 2003, Nr. 08, 6. August 2003 (2003-08-06) & JP 2003 109836 A (NEC TOKIN CORP), 11. April 2003 (2003-04-11)
- PATENT ABSTRACTS OF JAPAN Bd. 017, Nr. 173 (E-1345), 2. April 1993 (1993-04-02) & JP 04 328812 A (YOSHIKO SAITOU), 17. November 1992 (1992-11-17)
- PATENT ABSTRACTS OF JAPAN Bd. 013, Nr. 088 (E-721), 28. Februar 1989 (1989-02-28) & JP 63 266808 A (HITACHI LTD), 2. November 1988 (1988-11-02)

## Beschreibung

Die Erfindung bezieht sich auf ein Verfahren zur Messung eines Fehlerstroms. Daneben bezieht sich die Erfindung auf eine allstromsensitive Fehlerstrom-Messeinrichtung unter Anwendung dieses Verfahrens. Eine solche Messeinrichtung soll insbesondere als Auslöser für einen Fehlerstrom-Schalter verwendbar sein.

Fehlerstrom-Auslöser sind vom Stand der Technik bekannt. Sie dienen zur Erkennung eines Fehlerstromes, so dass ein Schaltgerät den fehlerhaften Stromkreis abschalten kann. Derartige Auslöser werden gemeinsam mit dem Schaltgerät kurz als FI- oder DI-Schalter bezeichnet.

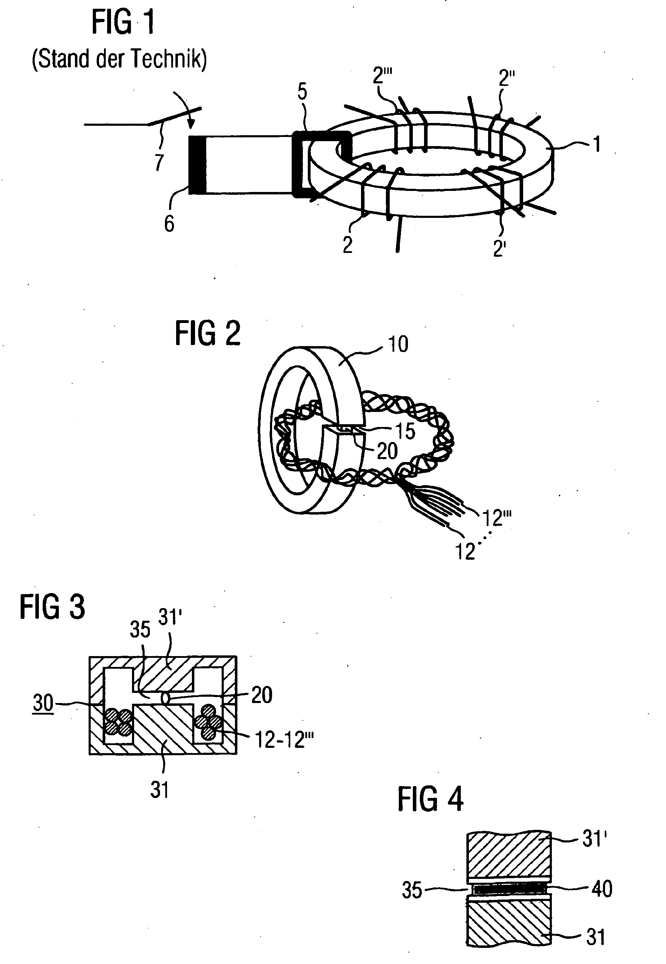

Bei vom Stand der Technik bekannten FI-Schaltern besteht der Auslöser üblicherweise aus einem Summenstromwandler mit mehreren Primärwindungen und einer Sekundärwindung sowie einer magnetisch betätigten Entklinkungsvorrichtung mit Auslösemagneten und Klappanker. Eine solche bekannte Einrichtung ist in der Figur 1 des speziellen Beschreibungsteiles weiter unten dargestellt. Mit dem dort vorhandenen Auslöser wird über den Klappanker das Schaltschloss des Schaltgerätes angesteuert und gegebenenfalls freigegeben. Speziell bei DI-Schaltern wird anstelle des Auslösemagneten eine Elektronikschaltung mit Hilfsmagneten eingesetzt.

Bei den bekannten Anordnungen sind die Primärwicklungen auf dem Ringkern angeordnet. Die Summenbildung des Stromes erfolgt im Magnetkern.

Nachteilig ist beim Stand der Technik die aufwändige und damit teure Ausbildung der Entklinkungsvorrichtung.

Aus der EP-A-0 157 054 ist ein Verfahren zur Messung eines Fehlerstroms bekannt, bei dem mehrere stromführende Leiter als Wicklungen vorhanden sind, eine Summenbildung der in den Leitern fließenden Ströme vorgenommen wird und die Fehlerströme mit einem Magnetfeldsensor detektiert werden. Dabei werden die Leiter so angeordnet, dass sich bei einem Summenstrom von Null die aus den Strömen resultierenden Magnetfelder in wenigstens einem Punkt des umgebenden freien Raums aufheben, wodurch die Summenbildung der in den Leitern fließenden Ströme im resultierenden Magnetfeld der Leiter erfolgt. Im magnetfeldfreien Punkt wird ein Magnetfeldsensor angeordnet, der bei Auftreten eines Fehlerstroms das aus der Summenbildung resultierende Magnetfeld als Fehlerstrom detektiert.

Aufgabe der Erfindung ist es daher, ein Verfahren anzugeben, mit dem in einfacher Weise Fehlerströme erfasst werden können, und eine Vorrichtung zu schaffen, die als Auslöser bei Fehlerstromschutzschaltern für Allstrom-Anwendungen, d.h. Wechsel- und Gleichströme, geeignet ist.

Die Aufgabe ist bezüglich des Verfahrens erfindungsgemäß durch die Maßnahmen des Patentanspruches 1 gelöst. Eine zugehörige Messeinrichtung ist durch die Merkmale des Patentanspruches 2 gekennzeichnet. Vorteilhafte Weiterbildungen sind in den Unteransprüchen angegeben.

Wesentlicher Punkt bei der vorzeichenbehafteten Summenbildung mehrerer Ströme zur Identifizierung von Fehlerströmen ist die Auswirkung der Stromwerte der Einzelleiter, in denen unter Umständen einige 100 A fließen können, auf die Summenbildung, die andererseits bei Vorhandensein von Fehlerströmen im Bereich von 10 mA diese sicher erkennen muss. Dies wird als "Common Mode Rejection" bezeichnet.

Allgemein betrachtet erfolgt bei der erfindungsgemäßen Anordnung - in wesentlicher Erweiterung zum Stand der Technik - die Summenbildung des Stromes zumindest teilweise bereits im resultierenden Magnetfeld um die Primärwicklungen ohne Mitwirkung eines Magnetkerns. Dafür sind die stromführenden Leiter derart angeordnet, dass sich bei einem Summenstrom von Null die aus den Strömen resultierenden Magnetfelder im freien Raum um die Leiter bereits weitgehend aufheben. In mindestens einem definierten Punkt des umgebenden freien Raumes heben sich die Felder durch Summenbildung sogar völlig auf. Durch einen Magnetkern kann der die Leiter umgebende magnetische Fluss konzentriert werden und damit die Common Mode Rejection weiter deutlich verbessert sowie Fremdfelder wirksam abgeschirmt werden. Insbesondere ist hierzu ein als Topfkern ausgebildeter Magnetkern geeignet.

Durch die Summenbildung der durch die in den Leitern fließenden Ströme bewirkten Magnetfelder ergibt sich an einem definierten Punkt ein Feld gleich Null. Wird ein Magnetkern eingesetzt, ist das Magnetfeld im Magnetkern und im Luftspalt des Magnetkerns Null. Zur Erfassung der aus der Summenbildung durch Fehlerströme von Null abweichenden Magnetfelder wird dort ein Magnetfeldsensor angeordnet. Damit wird für den Fall, dass Fehlerströme auftreten, ein für den jeweiligen Fehlerstrom signifikantes Signal erzeugt.

Bei der Erfindung sind die stromführenden Leiter, welche die Leitungen der Primärwicklungen bilden, miteinander verdrillt oder verroebelt.

Zur technischen Realisierung ist bei der Erfindung der Magnetkern durch wenigstens einen Topfkern oder M-Magnetkern gebildet. Durch spiegelbildliche symmetrische Anordnung zweier solcher Topfkerne wird eine nach außen geschlossene Anordnung gebildet. Zentral in dieser Anordnung ist ein Luftspalt vorhanden, in dem sich der Magnetfeldsensor befindet. Vorteilhafterweise kann der Magnetfeldsensor ein GMR-Sensor sein, der sich durch eine besondere Empfindlichkeit auszeichnet. Aber auch andere Magnetfeldsensoren, wie z.B. Hall-Sensoren oder AMR-Sensoren sind einsetzbar. Speziell für Wechselströme (AC) können auch spezifische Spulen, wie so genannte "Pickup"-Spulen, als Magnetfeldsensor verwendet werden.

Weitere Einzelheiten und Vorteile der Erfindung ergeben sich aus der nachfolgenden Figurenbeschreibung von Ausführungsbeispielen. Es zeigen jeweils in schematischer Form:
- Figur 1: einen FI-Auslöser nach dem Stand der Technik,
- Figur 2: das Prinzip des neuen FI-Auslösers,
- Figur 3: den praktischen Aufbau eines geschlossenen Topfkernes mit darin angeordneten Leitern und einem Magnetsensor sowie
- Figur 4: eine alternative Ausbildung eines Magnetsensors als "Pickup"-Spule.

In der Figur 1 ist ein vom Stand der Technik bekannter Auslöser für einen Fehlerstrom-Schutzschalter schematisch dargestellt. Er besteht in bekannter Weise aus einem Ringkern 1 mit einer Reihe von Primärwicklungen, beispielsweise den Primärwicklungen 2, 2', 2" und 2'''.

Die Primärwicklungen 2 bis 2'" bestehen jeweils aus stromführenden Leitungen, welche ein Magnetfeld erzeugen. Es ist weiterhin eine Sekundärwicklung 5 angedeutet, die den Ringkern 1 ebenfalls umgreift und von der über Ausgangsleitungen ein Auslösemagnet 6 angesteuert wird. Dem Auslösemagnet 6 ist ein Klappanker 7 zugeordnet.

Sofern durch einen Fehler in einer der stromdurchflossenen Leitungen die vorzeichenbehaftete Stromsumme nicht mehr Null beträgt, tritt im Magneten ein resultierendes Feld auf. Dies wird über die Sekundärwicklung erfasst. Über den Auslösemagneten 6 wird der Klappanker 7 betätigt, der ein in Figur 1 nicht dargestelltes Schaltschloss freigibt.

Bei der beschriebenen Anordnung erfolgen in bekannter Weise eine Summenbildung des Stromes im Magnetkern und eine Auslösung aufgrund der über die Induktion im Sekundärkreis aktivierbaren Auslösemagneten. Es ergibt sich eine vergleichsweise aufwändige Ausbildung der Entklinkungsvorrichtung als Auslöser für einen FI-Schalter.

In Figur 2 wird ein prinzipiell anderer Weg gegangen: Es ist wiederum ein Ringkern 10 entsprechend dem Ringkern 1 aus Figur 1 vorhanden, der aber nunmehr einen Luftspalt 15 mit einem Magnetfeldsensor 20 enthält.

Der Ringkern 10 umgibt in Figur 2 die zusammengeführten, stromführenden Leitungen 12, 12' ... 12ⁿ der einzelnen Wicklungen. Dafür ist es notwendig, dass die Leitungen 12, 12' ... 12ⁿ verdrillt oder insbesondere verroebelt sind. Dies bedeutet, dass eine Verdrillung mit einem vorgegebenen Wiederholmuster vorgenommen wird.

Bei einer solchen Anordnung der Leitungen 12, 12' ... 12^{n,} erfolgt die Summenbildung teilweise bereits im resultierenden Magnetfeld aller stromdurchflossenen Leiter 12, 12' ... 12^{n,} der einzelnen Primärwicklungen. Eine weitere Verbesserung der "Common Mode Rejection" und eine wirksame Abschirmung von Fremdfeldern erfolgt durch zusätzliche Applikation des Magnetkerns 10 mit Luftspalt 15. Im Luftspalt 15 ist das Magnetfeld minimiert so dass dort bereits eine Erfassung und Identifizierung der von unerwünschten Fehlerströmen bewirkten Magnetfeldänderungen erfolgen kann.

In der technischen Realisierung wird jedoch kein Ringkern, sondern insbesondere ein Magnetkern aus zwei Topfkernen verwendet, der zentral mit einem Luftspalt versehen ist. Im Luftspalt befindet sich ein Magnetsensor. Auch sog. M-Magnetkerne sind möglich.

Als Magnetsensor können bekannte Sensoren eingesetzt werden, insbesondere ein so genannter GMR (Giant Magnetic Resistance), der sich durch eine größtmögliche Empfindlichkeit auszeichnet. Gegebenenfalls können auch Magnetfeldsensoren auf der Basis von Hall-Sensoren oder AMR-Sensoren eingesetzt werden. Auch Spulen, wie insbesondere eine "Pickup"-Spule, sind magnetfeldempfindlich und können somit als Magnetfeldsensoren eingesetzt werden.

In der Figur 3 ist eine dafür geeignete Topfkernanordnung 30 dargestellt. Die Topfkernanordnung 30 besteht aus zwei Teilkernen 31, 31', die beispielsweise identisch aufgebaut sind und spiegelbildlich zusammengesetzt werden. Dadurch ergibt sich eine geschlossene Anordnung mit Innenräumen zur Aufnahme der Primärleiter und einem zentralen Luftspalt 35. Im oder am Luftspalt ist ein geeigneter Magnetsensor, beispielsweise der Magnetsensor 20 aus Figur 2, angeordnet.

Die Anordnung gemäß Figur 3 ist mit demnach außen geschlossenem Magnettopfanordnung aus zwei spiegelbildlich zusammengesetzten Topfkernen 31, 31' so aufgebaut, dass neben der Rotationssymmetrie auch eine Symmetrie zur Mittelebene erzielt ist, wodurch Fremdfelder weitestgehend unterdrückt werden.

In Figur 3 ist die elektrische Beschaltung nicht dargestellt. Das Ausgangssignal des Magnetsensors 20 wird einer bekannten Schwellwertschaltung zugeführt. Beim Überschreiten eines vorgegebenen Schwellwertes, der einem definierten Fehlerstrom entspricht, wird dann beispielsweise über einen Hilfsmagneten das Schaltschloss entklinkt und der fehlerhafte Hauptstromkreis unterbrochen.

In Figur 4 ist im Luftspalt 35 der Topfkernanordnung 30 eine so genannte "Pickup"-Spule 40 angeordnet. Die "Pickup"-Spule 40 dient als Sensor für von Wechselströmen erzeugte Magnetfelder. Mit einer solchen Anordnung können also speziell fehlerhafte Wechselströme erfasst und quantitativ gemessen werden.

Mit der neuen Anordnung ist es möglich, durch Parametrierung bzw. durch Veränderung des Schwellwertes den zulässigen Fehlerstrom zu verändern. Dadurch können mit der gleichen Anordnung verschiedene Anwendungen mit unterschiedlich zulässigen Fehlerströmen realisiert werden. Beispielsweise sind Fehlerströme von 10 mA, 30 mA oder auch 100 mA erfassbar.

Insgesamt ergibt sich ein kostengünstiger und allstromsensitiver Fehlerstromdetektor, der keine empfindlichen mechanischen Entklinkungsvorrichtungen benötigt. Die beschriebene Anordnung lässt sich besonders vorteilhaft in Verbindung mit elektronischen Leistungsschaltern einsetzen.

## Patentansprüche

1. Verfahren zur Messung eines Fehlerstroms, wobei
- mehrere stromführende Leiter (12 - 12ⁿ) als Primärwicklungen sowie ein Magnetkern (10, 30) und ein Magnetfeldsensor (20, 40) vorhanden sind, wobei der Magnetkern (10, 30) um die stromführenden Leiter (12 - 12ⁿ) angeordnet ist und der Magnetfeldsensor (20, 40) sich in einem Luftspalt (15, 35) des Magnetkerns (10, 35) befindet;
- eine Summenbildung der in den Leitern fließenden Ströme vorgenommen wird; und
- auftretende Fehlerströme mit einem Magnetfeldsensor detektiert werden, mit folgenden Maßnahmen:
- die stromführenden Leiter (12 - 12ⁿ) werden derart angeordnet, dass sich bei einem Summenstrom von Null die aus den Strömen resultierenden Magnetfelder in wenigstens einem Punkt des umgebenden freien Raumes gegenseitig aufheben,
- wodurch die Summenbildung der in allen Leitern (12 - 12ⁿ) fließenden Ströme im resultierenden Magnetfeld der stromführenden Leiter (12 - 12ⁿ) erfolgt,
- im magnetfeldfreien Punkt wird ein Magnetfeldsensor (20, 40) angeordnet, der bei Auftreten eines Fehlerstroms das aus der Summenbildung resultierende Magnetfeld als Fehlerstrom detektiert, **dadurch gekennzeichnet, dass** als stromführende Leiter (12 - 12ⁿ) untereinander verdrillte und/oder verroebelte Leiter (12 - 12ⁿ) verwendet werden.

2. Allstromsensitive Fehlerstrom-Messeinrichtung zur Durchführung des Verfahrens nach Anspruch 1, mit stromführenden Leitern (12 - 12ⁿ) als Primärwicklungen, einem Magnetkern und mit einem Magnetfeldsensor, wobei der Magnetkern (10, 30) um die stromführenden Leiter (12 - 12ⁿ) angeordnet ist und der Magnetfeldsensor (20, 40) sich in einem Luftspalt (15, 35) des Magnetkerns (10, 35) befindet, **dadurch gekennzeichnet, dass** die stromführenden Leiter (12 - 12ⁿ) untereinander verdrillt und/oder verroebelt sind.

3. Messeinrichtung nach Anspruch 2, dass die verdrillten und/oder verroebelten Leiter (12 - 12ⁿ) einen Ring bilden.

4. Messeinrichtung nach Anspruch 3, **dadurch gekennzeichnet, dass** der Ring ein kreisrunder Ring ist.

5. Messeinrichtung nach einem der Ansprüche 2 bis 4, **dadurch gekennzeichnet, dass** der Magnetkern als Ringkern (10) mit Luftspalt (15) im Ringumfang ausgeführt ist.

6. Messeinrichtung nach einem der Ansprüche 2 bis 5, **dadurch gekennzeichnet, dass** der Magnetkern als Topfkern mit zentrischem Luftspalt (35) ausgebildet ist.

7. Messeinrichtung nach einem der Ansprüche 2 bis 5, **dadurch gekennzeichnet, dass** der Magnetkern als so genannter M-Magnetkern (30) ausgebildet ist.

8. Messeinrichtung nach Anspruch 6, **dadurch gekennzeichnet, dass** der Magnetfeldsensor (20) im zentralen Luftspalt (35) des Topfmagnetkerns (10) angeordnet ist.

9. Messeinrichtung nach Anspruch 2, **dadurch gekennzeichnet, dass** der Magnetfeldsensor (20) ein GMR-Sensor ist.

10. Messeinrichtung nach Anspruch 2, **dadurch gekennzeichnet, dass** der Magnetfeldsensor (20) ein Hall-Sensor ist.

11. Messeinrichtung nach Anspruch 2, **dadurch gekennzeichnet, dass** der Magnetfeldsensor (20) ein AMR-Sensor ist.

12. Messeinrichtung nach Anspruch 2, wobei in den stromführenden Leitern (12 - 12ⁿ) Wechselströme fließen, **dadurch gekennzeichnet, dass** der Magnetfeldsensor eine Pickup-Spule (40) ist.

13. Messeinrichtung nach einem der vorhergehenden Ansprüche, **dadurch gekennzeichnet, dass** dem Magnetfeldsensor (20, 40) eine Schwellwertschaltung zugeordnet ist, der das Ausgangssignal des Magnetsensors (20, 40) zugeführt wird.

## Claims

1. Method for measuring a residual current, wherein
- a plurality of current-carrying conductors (12 - 12ⁿ) as primary windings as well as a magnetic core (10, 30) and a magnetic field sensor (20, 40) are provided, wherein the magnetic core (10, 30) is arranged around the current-carrying conductors (12 - 12ⁿ) and the magnetic field sensor (20, 40) is located in an air gap (15, 35) of the magnetic core (10, 35);
- a summation of the currents flowing in the conductors is performed; and
- residual currents that occur are detected with a magnetic field sensor, with the following actions:
- the current-carrying conductors (12 - 12ⁿ) are arranged such that if the summation current is zero the magnetic fields resulting from the currents cancel each other out in at least one point of the ambient free space,
- as a result of which the summation of the currents flowing in all conductors (12 - 12ⁿ) takes place in the resulting magnetic field of the current-carrying conductors (12 - 12ⁿ),
- a magnetic field sensor (20, 40) is arranged in the magnetic-field-free point and when a residual current occurs detects the magnetic field resulting from the summation as a residual current, **characterised in that** conductors (12 - 12ⁿ) twisted and/or transposed with one another are used as current-carrying conductors (12 - 12ⁿ).

2. Current-sensitive residual current measuring device for implementation of the method according to claim 1, having current-carrying conductors (12 - 12ⁿ) as primary windings, a magnetic core and having a magnetic field sensor, wherein the magnetic core (10,30) is arranged around the current-carrying conductors (12 - 12ⁿ) and the magnetic field sensor (20,40) is located in an air gap (15, 35) of the magnetic core (10, 35), **characterised in that** the current-carrying conductors (12 - 12ⁿ) are twisted and/or transposed with one another.

3. Measuring device according to claim 2, **characterised in that** the twisted and/or transposed conductors (12 - 12ⁿ) form a ring.

4. Measuring device according to claim 3, **characterised in that** the ring is a circular ring.

5. Measuring device according to one of claims 2 to 4, **characterised in that** the magnetic core is designed as an annular core (10) with an air gap (15) in the circumference of the ring.

6. Measuring device according to one of claims 2 to 5, **characterised in that** the magnetic core is designed as a cup-type core with a centric air gap (35).

7. Measuring device according to one of claims 2 to 5, **characterised in that** the magnetic core is designed as a so-called M-magnetic core (30).

8. Measuring device according to claim 6, **characterised in that** the magnetic field sensor (20) is arranged in the central air gap (35) of the cup-type magnetic core (10).

9. Measuring device according to claim 2, **characterised in that** the magnetic field sensor (20) is a GMR sensor.

10. Measuring device according to claim 2, **characterised in that** the magnetic field sensor (20) is a Hall sensor.

11. Measuring device according to claim 2, **characterised in that** the magnetic field sensor (20) is an AMR sensor.

12. Measuring device according to claim 2, wherein alternating currents flow in the current-carrying conductors (12 - 12ⁿ), **characterised in that** the magnetic field sensor is a pick-up coil (40).

13. Measuring device according to one of the preceding claims, **characterised in that** a threshold value circuit, to which the output signal of the magnetic sensor (20, 40) is passed, is assigned to the magnetic field sensor (20, 40).

## Revendications

1. Procédé de mesure d'un courant de défaut, dans lequel :
- il y a plusieurs conducteurs de courant (12 à 12ⁿ) comme enroulements primaires ainsi qu'un noyau magnétique (10, 30) et un capteur de champ magnétique (20, 40), le noyau magnétique (10, 30) étant agencé autour des conducteurs de courant (12 à 12ⁿ) et le capteur de champ magnétique (20, 40) se trouvant dans un entrefer (15, 35) du noyau magnétique (10, 30) ;
- on forme une somme des courants passant dans les conducteurs ; et
- on détecte des courants de défaut qui apparaissent avec un capteur de champ magnétique ;
avec les mesures suivantes :
- les conducteurs de courant (12 à 12ⁿ) sont agencés de telle sorte que, pour un courant total nul, les champs magnétiques résultant des courants s'annulent mutuellement en au moins un point de l'espace libre alentour,
- ce qui fait que la formation de somme des courants passant dans tous les conducteurs (12 à 12ⁿ) s'effectue dans le champ magnétique résultant des conducteurs de courant (12 à 12ⁿ),
- un capteur de champ magnétique (20, 40) est agencé au point exempt de tout champ magnétique, lequel capteur de champ magnétique détecte comme courant de défaut, lors de l'apparition d'un courant de défaut, le champ magnétique résultant de la formation de somme,
**caractérisé par le fait que** l'on utilise comme conducteurs de courant (12 à 12ⁿ) des conducteurs (12 à 12ⁿ) torsadés et/ou du type Roebel.

2. Dispositif de mesure de courant de défaut sensible à tout courant pour la mise en oeuvre du procédé selon la revendication 1, avec des conducteurs de courant (12 à 12ⁿ) comme enroulements primaires, avec un noyau magnétique et avec un capteur de champ magnétique, le noyau magnétique (10, 30) étant agencé autour des conducteurs de courant (12 à 12ⁿ) et le capteur de champ magnétique (20, 40) se trouvant dans un entrefer (15, 35) du noyau magnétique (10, 30) ; **caractérisé par le fait que** les conducteurs de courant (12 à 12ⁿ) sont torsadés et/ou du type Roebel.

3. Dispositif de mesure selon la revendication 2, **caractérisé par le fait que** les conducteurs torsadés et/ou du type Roebel (12 à 12ⁿ) forment un anneau.

4. Dispositif de mesure selon la revendication 3, **caractérisé par le fait que** l'anneau est un anneau rond.

5. Dispositif de mesure selon l'une des revendications 2 à 4, **caractérisé par le fait que** le noyau magnétique est réalisé comme un noyau annulaire (10) avec entrefer (15) dans la circonférence annulaire.

6. Dispositif de mesure selon l'une des revendications 2 à 5, **caractérisé par le fait que** le noyau magnétique est réalisé comme un noyau en pot avec entrefer central (35).

7. Dispositif de mesure selon l'une des revendications 2 à 5, **caractérisé par le fait que** le noyau magnétique est réalisé comme un noyau magnétique dit M (30).

8. Dispositif de mesure selon la revendication 6, **caractérisé par le fait que** le capteur de champ magnétique (20) est agencé dans l'entrefer central (35) du noyau magnétique en pot (10).

9. Dispositif de mesure selon la revendication 2, **caractérisé par le fait que** le capteur de champ magnétique (20) est un capteur GMR.

10. Dispositif de mesure selon la revendication 2, **caractérisé par le fait que** le capteur de champ magnétique (20) est un capteur Hall.

11. Dispositif de mesure selon la revendication 2, **caractérisé par le fait que** le capteur de champ magnétique (20) est un capteur AMR.

12. Dispositif de mesure selon la revendication 2, dans lequel des courants alternatifs passent dans les conducteurs de courant (12 à 12ⁿ), **caractérisé par le fait que** le capteur de champ magnétique est une bobine Pickup (40).

13. Dispositif de mesure selon l'une des revendications précédentes, **caractérisé par le fait qu'**il est associé au capteur de champ magnétique (20, 40) un circuit à valeur de seuil auquel est envoyé le signal de sortie du capteur de champ magnétique (20, 40).
